Europäisches Patentamt

European Patent Office

Office européen des brevets

(19)

(11) EP 0 632 376 B1

(12) **EUROPEAN PATENT SPECIFICATION**

(45) Date of publication and mention
of the grant of the patent:
**11.02.1998 Bulletin 1998/07**

(51) Int Cl.6: **G06F 11/00**, G06F 11/10

(21) Application number: **94109687.7**

(22) Date of filing: **23.06.1994**

(54) **Encoding and rebuilding the data content of up to two unavailable DASDs in a DASD array**

Kodierung und Rekonstruktion des Dateninhaltes von bis zu zwei nichtverfügbaren DASDs in einer DASD-Anordnung

Codage et reconstruction du contenu de données de pas plus que, deux DASDs non-disponibles dans un réseau de DASDs

(84) Designated Contracting States:
DE FR GB

(30) Priority: **30.06.1993 US 85707**

(43) Date of publication of application:
**04.01.1995 Bulletin 1995/01**

(73) Proprietor: **INTERNATIONAL BUSINESS MACHINES CORPORATION**
**Armonk, NY 10504 (US)**

(72) Inventors:
• **Blaum, Miguel Mario**
 **San Jose, California 95119 (US)**
• **Brady, Jim**
 **San Jose, California 95120 (US)**
• **Bruck, Jehoshua**
 **Palo Alto, California 94306 (US)**

• **Menon, Jaishankar M.**
 **San Jose, California (US)**

(74) Representative: **Zerbi, Guido Maria et al**
**Intellectual Property Department,**
**IBM United Kingdom Ltd.,**
**Hursley Park**
**Winchester, Hampshire SO21 2JN (GB)**

(56) References cited:
 **EP-A- 0 499 365**  **EP-A- 0 518 603**
 **EP-A- 0 519 669**

• **PROCEEDINGS 21ST ANNUAL INT.
SYMPOSIUM ON COMPUTER ARCHITECTURE,
18 April 1994, CHICAGO, IL., USA M. BLAUM ET
AL. 'EVENODD: An Optimal Scheme for
Tolerating Double Disk Failures in RAID
Architectures'**

## Description

This invention relates to arrays of failure independent direct access storage devices (DASDs), and more particularly, to maintaining availability of data stored on said DASD arrays even where up to two DASDs in the array are concurrently rendered unavailable as by erasure of their contents.

In the prior art, the spreading of data blocks across DASD arrays to enhance access, data rate, fault tolerance, and recovery of array stored data blocks has been well appreciated. Of particular interest, is the use of simple parity for the correction of single DASD failures or erasures (Ouchi) and the use of more complex redundancy codes to correct up to two (Blaum I, II) or even three (Blaum III) concurrent failures. In order to return DASD array operation from a degraded mode upon the occurrence of failure to a fault tolerant mode, it is known to employ some DASDs as hot spares (Dunphy) which can be switched in to replace failed DASDs and be available to store rebuilds of the missing or erased data. It is also known to reserve spare space (Mattson I) among the DASDs of an array equivalent to some number of DASDs which might be expected to fail so as to maintain availability even though array operation would continue in a degraded mode or to effectuate load balancing (Mattson II).

Striping and Parity Encoding Records Over DASD Arrays and Recovery from Single DASD Failure By Modulo 2 Addition

Ouchi, US Pat 4,092,732, "System for Recovering Data Stored in a Failed Memory Unit", issued 5/30/78, discloses the spreading of data blocks from the same logical file across a string of N-1 failure independent DASDs and recording a parity block on the Nth DASD. According to Ouchi, the parity block is an XORing of the contents of the N-1 other blocks. Contents from any single inaccessible DASD can be recovered by XORing the parity blocks with the blocks stored on the N-2 remaining accessible DASDs. In the event of a single failure, Ouchi is operated in a degraded mode since any additional failure until a spare disk is reconstituted would render the subsystem totally unavailable. This feature was later re described in Hartness, USP 4,775,978, "Data Error Correction System", issued 10/4/1988.

In an Ouchi type array, correction of blocks requires identification of failed DASDs. This can be achieved by Hamming codes. However, such codes are usually used on a bit rather than block interleaved DASD array and the number of DASDs dedicated to redundancy is a significant fraction of the total as reported by Patterson et al, "A Case For Redundant Arrays Of Inexpensive Disks (RAID)", Report No. UCB/CSD 87/391, December 1987, Computer Science Division, U. of California, Berkeley.

In contrast, block interleave and simple parity coding as set forth in Ouchi permit a near infinite parity domain or striping width and only one redundant DASD need be involved. However, the identification of any failed DASD must be obtained independently such as by threshold ECC retry or equivalent. Reference should also be made to Dunphy et al, US Patent 4,914,656, "Disk Drive Memory", issued 4/3/90.

Data Availability, Hot Sparing, and Spare Space

The fastest recovery from DASD failure is to electronically switch to a completely duplicated or mirrored data set stored on a second storage domain. This obviously doubles storage costs. DASD arrays, as described by Ouchi and Dunphy, assume that the probability of a single DASD failure in an array is high while that of concurrent DASD failure is low. Further, in order to return a system having had a single failure back to fault tolerant state, hot sparing should be used.

Hot sparing, as defined by Dunphy, involves reserving one or more DASDs, substituting a spare to a domain after a DASD within that domain has failed, and rebuilding the otherwise unavailable blocks onto the spare. As long as the DASD failures are not nested within the interval defined by DASD failure and the completion of rebuilding data onto the spare, then the mean time between data unavailability can be very long indeed. Further, single DASD correction + sparing per Ouchi and Dunphy keep the number of idle or redundant DASDs to a minimum.

An alternative to hot sparing is to reserve space on some patterned basis among the array DASDs equal to some number of failed DASDS for purposes either of maintaining availability even when operating in degraded mode or to assist load balancing especially in respect of sequential write updates. This is described in copending applications , Mattson et al, USSN: 07/714,969, filed June 13, 1991, "Method and Means for Distributed Sparing in DASD Arrays" corresponding to EP-A-0 518 603, or Mattson et al, USSN: 07/562,188, filed August 3, 1990 , "Method and Means for Managing DASD Array Accesses When Operating in Degraded Mode".

Array Data Rebuild for Up to Two DASD Failures

Copending application Blaum et al (Blaum I), USSN:07/653,596, filed 02/11/1991, "Method and Means for Encoding and Rebuilding the Data Contents of Up to Two Unavailable DASDs in an Array of DASDs" corresponding to EP-A-0 499 365 teaches a method for coding and rebuilding (M-1)∗M symbol data array onto an M synchronous DASD array when up to two DASDs fail, M being a prime number. Pairs of simple parities are recursively coded in respective diagonal major and intersecting row major order data array directions covering a topological torus. Rebuilding data upon unavailability of no more than two DASDs requires a simple recursive operation similar to the encoding step, and involving exclusive-OR operations only.

The coding (either encoding or rebuilding) in Blaum I involves repeatedly alternating a diagonal parity assignment with a row parity assignment in zig/zag fashion so as to cover the entire $(M-1)*M$ data array according to a deterministic process. Each of the M diagonal parity assignments involves XORing M-2 data elements and placing the result in a first parity position. This is followed by XORing of the M-1 data elements of the row intersecting the first parity position and placing the result in a second parity position in that row.

Copending application Blaum et al (Blaum II), SA9-91-051, USSN: 07/751,950, filed August 29, 1991, "Method and Means For B-Adjacent Coding and Rebuilding Data From Up to Two Unavailable DASDS in a DASD Array" discloses a method and means for correcting portions of a data string stored on up to two unavailable DASDs in a DASD array using B-adjacent coding. In Blaum II, the method steps comprise (a) independent identification of the failed DASDs and (b) formation and resolution of a pair of syndromes obtained from the blocks of the same string on the remaining DASDs. The syndrome pair $(S(0),S(1))$ consist of two independent Boolean equations in two unknowns.

In Blaum II, each data string is segmented into N data blocks + 2 redundant blocks and then written across N counterpart DASDs. The redundant blocks $(R(0),R(1))$ are computed over the string. The first redundant block, $R(0)$, is the XOR of N-2 data blocks while the second redundant block, $R(1)$, is the modulo 2 sum of the products of a primitive element in a finite field (Galois field) raised to a declining power ($a5(N-i)$) and the modulo 2 data value ($b(i)$), of a counterpart one of N other blocks.

### An Array Data Rebuild for Up to Three DASD Failures

Copending application Blaum et al (Blaum III), USSN: 07/718,724, filed June 21, 1991, "Error Correction Codes For Multiple Failures In Disk Arrays And The Like" corresponding to EP-A-0 519 669 is a code extension to that disclosed in Blaum I. Relatedly, the Blaum III method steps include parity coding and writing an $(M-1)*(M-3)$ data block array onto a synchronous M DASD array, predetermined ones of the DASDs being reserved for storing parity; and responsive to the unavailability of up to three DASDs, rebuilding the data by repeating the coding step using data from the M-3 available DASD's on a scheduled or opportunistic basis and rewriting the rebuilt data onto spare capacity.

In Blaum III, the coding (either encoding or rebuilding) of the $(M-1)*M$ block array includes following a traverse emulating the positively sloped motions of a chess rook, bishop, and knight extended cyclically over the data array such that the logically combined (XOR'ed) values over the traverses sum to zero. Blaum III is extensible to recovery from more than three DASDs by modification of the metaphoric knight's code traverse to include increasingly steeper slopes.

### The Two Meanings of Parity or Redundancy Group

As used in the above identified Dunphy patent, "parity group" denotes a logical association of N DASDs including at least a (N+1)-st DASD dedicated to storing parity taken there across. However, the term also refers to a logical association of data blocks and a parity or other algebraic coded redundant block taken there across. Patterson uses the latter definition in discussion of the RAID type 5 DASD array.

### Data Error and Erasure

"Data error" means any change in stored value as a consequence of a random noise or burst process. In systems storing binary values such as 1 1 1 0 0 1 0 0 , remanent magnetization states change such that some 1's become 0's and some 0's become 1's. This might appear as 1 1 0 0 0 1 0 1. Here, the values in the 3rd and 8th positions from the left are random errors.

"Erasure" is an error for which the error location is known but the error magnitude is NOT known. That is, an erasure is the removal of any data value in a storage location. For example, the data string 1 x x x x 1 0 0 omits any binary values in positions 2 through 5.

It is therefore an object of the present invention to overcome the above drawbacks of the prior art.

According to the present invention, we provide, in a system having a plurality of DASDs, a portion of said plurality of DASDs forming an array of M failure independent DASDs, said subsystem further having means responsive to external commands for accessing subsets of data blocks logically addressed in an $(M-1)*(M-2)$ array of data blocks from said M DASDs, M being a prime number, said data block array having a major or reference diagonal, said data blocks being arranged in said data block array in diagonal and row major order, each diagonal and row order of data blocks having a parity mode, odd or even, one of said plurality of DASDs being desiganted as spare, a method for encoding and rebuilding of the contents of said array in the event that up to two DASD's from the M DASD array become unavailable, comprising the steps of:

(a) ascertaining the parity mode of the major diagonal of data blocks in the (M-1)*(M-2) data block array;

(b) generating an (M-1)*(M) data block array from said (M-1)*(M-2) data array by forming an (M-1)th column by calculating simple parity values from the data blocks in diagonal major order according to the same parity mode, odd or even, of step (a) and by forming an M-th column by calculating for each of the rows simple parity values from the data blocks in row major order according to an even parity mode;

(c) writing said (M-1)*M data block array onto counterpart locations across the M DASD array or spare equivalent in the event of DASD unavailability; and

(d) responsive to the unavailability of up to two DASDs, rebuilding the erased or unavailable portion of said data array from no less than (M-2) available DASDs, such that:

(1) if the two failed DASDs consist of the DASDs storing the diagonal parity (M-1)st DASD) and row parity (Mth DASD) values respectively, then repeating step (b) and writing the reconstituted row and parity values to the spare DASD substitutes for the (M-1)st and Mth DASDs respectively,

(2) if the two failed DASDs consist of a DASD (ith DASD) storing data blocks and the DASD (Mth DASD) storing row parity values, then reconstructing the ith DASD by ascertaining the parity mode of the major diagonal, calculating each data block of the ith DASD by XOR'ing only the data blocks lying along the diagonal intersecting the ith DASD according to the ascertained parity mode, and reconstructing the Mth DASD by calculating each row parity value by XOR'ing only the data blocks lying along the row intersecting the Mth DASD, and writing said calculated data blocks and row parity values to the spare DASD substitutes for the ith DASD and Mth DASD respectively,

(3) if the two failed DASDs consist of a DASD (ith DASD) storing data blocks and a DASD ((M-1)st) storing diagonal parity values, then reconstructing the ith DASD by calculating each data block of the ith DASD by XOR'ing each of the remaining data blocks and the row parity value intersecting the ith DASD, and reconstructing the (M-1)st DASD by ascertaining the parity mode of the major diagonal, calculating each diagonal parity value by XOR'ing the data blocks lying along the diagonal intersecting the (M-1)st DASD, together with said parity mode of the major diagonal, and writing said calculated data blocks and diagonal parity values to the spare DASD substitutes for the ith DASD and (M-1)st DASD respectively, and

(4) if the two failed DASDs consist of a pair of DASDs (ith and jth DASDS) storing data blocks, then ascertaining the parity mode of the major array diagonal as being odd if the XOR of the diagonal parity values is not equal to the XOR of the row parity values and as being even otherwise, ascertaining each data block value in either the ith or jth DASD as the XOR solution to a single equation with a single unknown formed by either a diagonal of data blocks and diagonal parity value intersecting said each data block being calculated or a row of data blocks and row parity value intersecting said each data block being calculated, and writing said calculated data blocks to the spare DASD substitutes for the ith and jth DASDs.

Brief Description of the Drawings

Figure 1 shows a higher level RAID DASD array illustrating striping, parity encoding, sparing, and data redo on spares.

Figure 2 sets forth the control flow for non-recursive simple parity coding elements of an (M-1) * (M-2) data block array in diagonal major and row major order.

Figure 3 illustrates the control flow for non-recursive simple parity coding elements of an (M-1) * M data block array in diagonal major and row major order for execution of short write operations.

Figure 4 depicts control flow for data rebuild in the event of up to two DASD failures.

Description of the Preferred Embodiment

An Overview of Reading and Writing to the DASD Array

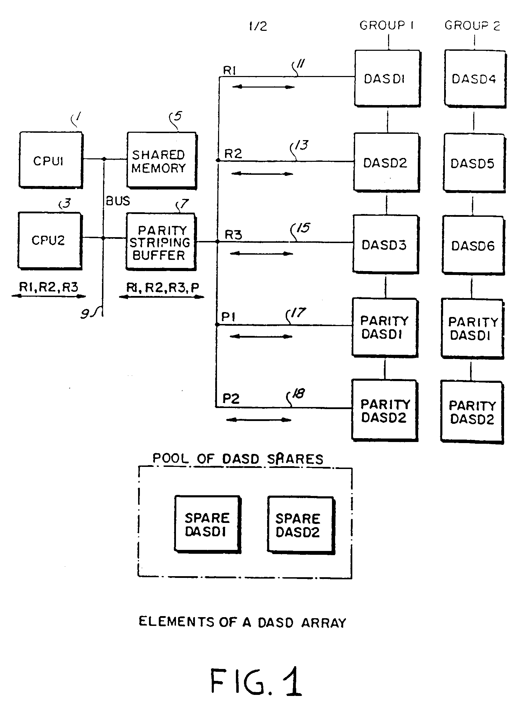

Referring now to figure 1, there is shown an array comprising a first and second DASD parity group coupling an intelligent parity generating and striping buffer (PSB) 7 over parallel paths 11, 3, 15, and 17. A processor array formed from CPU1 and CPU2 is coupled to data and control bus 9.

Processor 1 or 3 originated read and write commands establish a table directed access path to a group of DASDs (GROUP 1 or 2) by way of a standard accessing protocol and data movement over bus 9 shared memory 5 to PSB 7. The logical processing of a logical file is executed at PSB 7. In this regard, logical processing includes both striping (serial/parallel conversion of data) and parity generation and checking. The paths to and from the DASDs are table directed. In principle, an address specified in a read or write argument is translated by the PSB 7 via an array storage address table into the actual physical path between PSB 7 and the location on the DASDs of the requisite group of DASDs. For purposes of this invention, a group such as DASDs forming GROUP 1 will be considered as an array of M DASDs. Additional DASDs as "hot spares" are also available for inclusion into the array upon failure of up to two of the M array DASDs. This is described for instance in Dunphy et al, USP 4,914,656.

To execute a write update command, PSB 7 must first buffer the new data block from the processor, read and buffer the old data block, and in the case of this invention, two parity blocks stored on the M DASD array. A new diagonal and row parities are computed taking the old data, old parity, and new data into account, and then the new data block and new parities are recorded in place on the counterpart array DASDs.

For a read operation, PSB 7 responsive to a read command from a processor performs inverse operation sequence to that of writing. That is, the data array within which the data to be read must be extracted is buffered in PSB 7, appropriate row and diagonal parities tested, and the addressed data transferred across bus 9 to shared memory 5.

DASD Failure and Hot Sparing

In the event that a DASD failure occurs while read accessing data, PSB 7 can select one from a number of alternatives. These include regenerating corrupted data on-the-fly either by either (1) retry of the read command or (2) reconstruction of the data from remaining DASDs and replacement according to the method of the invention.

With respect to the processor 1 or 3 originating the read command, one strategy is to notify it of the failure occurrence only AFTER completion of the read data movement. This would permit the processor to control substitution of a spare DASD from a pool or from a DASD reserved exclusively to each parity group in the manner of Park et al. Responsive to processor commands such as DISABLE and RECONSTRUCT, PSB 7 can cause the failed DASD to be replaced with a designated spare DASD by table substituting the directory path to the spare for the table directory path of the failed DASD. Next, the data on the failed DASD can be rebuilt on the designated spare DASD.

In one embodiment, PSB 7 stores a bit map of DASD availability and address map of the DASDs. In turn, the availability and address maps are referenced during the processing of each access command. Alterations to the maps may be originated by the processor using the DISABLE and RECONSTRUCT commands. In such an implementation, a permanent address is assigned to the SPARE DASD. Significantly, after failure notification, the processor 1 or 3 can address map of the DASDs. In turn, the availability and address maps are referenced during the processing of each access command. Alterations to the maps are originated by the processor using the DISABLE and RECONSTRUCT commands. The present implementation assigns a permanent address to the SPARE DASD.

Significantly, after failure notification, the processor can

(1) elect to do nothing; OR

(2) generate commands causing the addresses of the spare DASDs to be substituted for the addresses for up to two of the failed DASDs; AND

(3) reconstruct the contents of up to two failed DASD on the assigned spares by modulo 2 addition of parities plus remaining DASDs storing data blocks according to the reconstruction method set out below.

Note, the dynamic substitution of a spare formatted DASDs for other DASDs on-line is termed "hot sparing".

Flow Diagram of the Method of the Invention

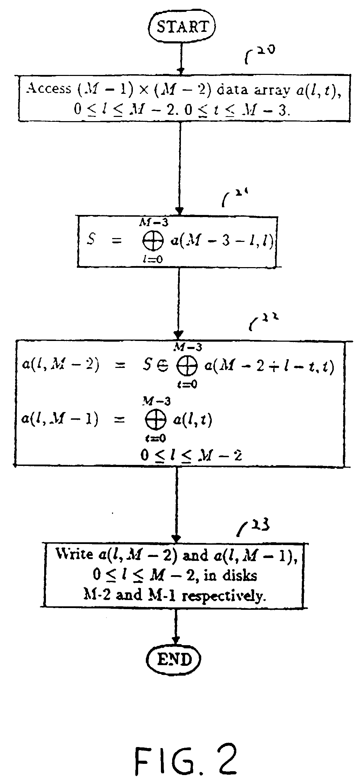

Referring now to figures 2, 3 and 4, there is shown the control flow for non-recursively simple parity coding elements of an (M-1)∗ M data block array in diagonal major and row major order for execution of short write operations and responsiveness in the event of DASD failure or erasure. That is, data blocks projected onto a logical array in the form of rows and columns can have redundancy values calculated over predetermined traverses or subsets of data blocks such as diagonals and rows of the array. The redundancy values are then stored on either additional DASDs or on space reserved on the array DASDs. Portions of the data resident on up to two unavailable DASDs may be rebuilt using the parity values and then rewritten to spare DASDs or to reserved spare space among the M-2 remaining DASDs.

In this invention, the term "encoding" means the computation of a redundancy value over a predetermined subset of data blocks. The term "rebuilding" means the calculation of either a data block or a parity block by the same process as the redundancy computation using a subset of data blocks and redundancy values. The term "XOR" means the exclusive OR operation operating over a binary field.

The method of this invention eliminates recursions in the encoding and short write operations, replacing them with simple parity checks of data, i.e., a row and diagonal parity checks. The short write operation is simplified since any modified data block affects only two redundancy (parity) values most of the time.

This invention assumes an array of M DASDs where M is a PRIME number. Data blocks are arranged in a logical (M-1)*M array such that if a(i,j) is the ith block stored on the jth DASD.

i lies in the closed interval [0, M-2] and j lies in the closed interval [0, M-1]. The requirement that M is a prime number is not really a limitation, since in case that less than M DASDs are needed, the code can always be shortened by assuming that an adequate number of (fictitious) DASDs store only zeros.

Data blocks are stored on the first M-2 DASDs while the parity values are stored on the (M-1)-th and M-th DASDs. Alternatively, parity values could be distributed across the DASD array such as described in Mattson I and II.

The parity values assume that the blocks a(M-1,j) = 0 where j lies in the interval [0, M-1]. In other words, a (fictitious) all-zero row is assumed. In figures 2, 3 and 4, it is also assuming that all the sub indices are taken modulo M.

Next the encoding is explicitly described, short write operations and reconstruction (decoding) whose equations are given in Figures 2, 3 and 4.

## Encoding

The encoding is described in Figure 2. The values of the redundancy a(t,M-2) and a(t,M-1) are given in box 22, where t lies in the interval [0,M-2]. The value S of the parity of the special diagonal (M-3,0),(M-4,1),...,(0,M-3) is previously calculated in box 21. This value of S determines the parity of all the other diagonals, either odd or even. Explicitly, from a procedural view, the parity of the diagonal (M-3,0), (M-4,1),...,(0,M-3) is taken as the mode governing the parity of the remaining diagonals taken in diagonal major order.

If the data blocks sited along this major or reference diagonal exhibit an even number of 1's, then even parity governs the remaining diagonals. The parity of the rows is always taken as even. It should be noted that the binary case is illustrated, but the block symbols can belong to any alphabet.

The writing operation of the values estimated in box 22 is done in box 23.

## Short Write Operations

By a short write operation, a data block a(i,j) is replaced where i lies in the interval [0,M-2] and j lies in the interval [0,M-3], by another arbitrary data block r. This operation will affect the redundant blocks. Most of the time, only two redundant blocks will have to be modified, except when the data block a(i,j) being rewritten lies in the reference diagonal (M-3,0),(M-4,1),...,(0,M-3). In this case, all the diagonal parities will have to be modified. The horizontal parity is modified as in the previous case. None of these two cases involves recursions.

The (M-1)xM array is accessed in box 31. Box 32 receives the input r of the value that will replace a(i,j). Box 33 executes and buffers the operation a(i,j) XOR r. In box 34, the actual operation of writing r in location (i,j) and a(i,m-1) XOR a(i,j) XOR r in location (i,m-1) is implemented. Box 35 checks if entry (i,j) lies in the reference diagonal (M-3,0), (M-4,1),...,(0,M-3). If it does not, then, in box 36, the operation of writing a(i+j+2,M-2) XOR a(i,j) XOR r in entry (i+j+2,M-2) is implemented. If it does, then, in box 37, the operation of writing a(t,M-2) XOR a(i,j) XOR r in entries (t,M-2) for each t in the interval [0,M-2] is implemented.

## Decoding (Reconstruction)

This step allows us to reconstruct the content of any two unavailable DASDs from the remaining M-2 DASDs.

The (M-1)xM array is accessed in box 401. In box 402, the input i and j of the two unavailable DASDs is received, where i<j, i and j lie in the interval [0,M-1]. Box 403 checks if j is M-1, i.e., the DASD containing the horizontal redundancy. If it is, then the parity of the diagonals is estimated in box 405 (odd or even), as in the encoding operation. Then, the values of the missing entries a(t,i) and a(t,M-1) are estimated in box 406, where t is in the interval [0,M-2]. The reconstructed values are written in spare disks replacing the unavailable DASDs i and M-1 in box 412.

Notice that in the particular case in which i=M-2, then the encoding equations of Figure 2 are again obtained. In that sense, the encoding is a particular case of the decoding.

If the answer from box 403 is no, then box 404 checks if j is M-2, i.e., the DASD containing the diagonal redundancy. If the answer is yes, then the first step is retrieving the entries a(t,i), where t lies in the interval [0,M-2]. This is done in box 408 using the horizontal parities a(t,M-1). Once the entries a(t,i) are recovered, the diagonal parity S in box 409 is estimated. Then, in box 410, the diagonal parities a(t,M-2), t in the interval [0,M-2] are obtained. The reconstructed values are written in spare disks replacing the unavailable DASDs i and M-2 in box 412.

If the answer to box 404 is no, then we are in the main case, that is, two DASDs i and j carrying data blocks are unavailable. None of the redundant DASDs is affected. In box 407, the diagonal parity is determined, by exclusive-OR (XOR'ing) all the redundant symbols a(t,M-2) and a(t,M-1). Then, the data lost in DASDs i and j are retrieved in box 411. Notice that the operations in box 411 are a recursion. The index 1 runs from 1 to M-1. The entries are retrieved in the order indicated in box 411, starting with l=1 and ending with l=M-1 . So, a recursion at the decoding is needed, but only in the event of a double disk failure, which is not very frequent. As before, the reconstructed values are written in spare DASDs replacing the unavailable DASDs i and j in box 412. In the next section examples of the encoding are given, short write operations and decoding described in figures 2, 3 and 4.

Illustrative Examples

Encoding

Assume that it is desired to store data blocks on an array of M=5 DASDs. Let the data and parity blocks and values be denoted by a(i,j) where i lies in [0,3] and j lies in [0,4]. The parity S of the data blocks taken along the reference diagonal (M-3,0), (M-4,1),...(0,M-3), according to box 21 in Figure 2, would be expressed as:

$$S = a(2,0) \text{ XOR } a(1,1) \text{ XOR } a(0,2).$$

Using the equations in box 22 of Figure 2, it follows that the M-2 diagonal parity values to be stored on the (M-1)-th DASD can be determined according to:

$$a(0,3) = a(3,0) \text{ XOR } a(2,1) \text{ XOR } a(1,2) \text{ XOR } S$$

$$a(1,3) = a(3,1) \text{ XOR } a(2,2) \text{ XOR } S$$

$$a(2,3) = a(0,0) \text{ XOR } a(3,2) \text{ XOR } S$$

$$a(3,3) = a(1,0) \text{ XOR } a(0,1) \text{ XOR } S$$

The M-1 row parity values stored in the Mth DASD are formulated per:

$$a(i,4) = a(i,0) \text{ XOR } a(i,1) \text{ XOR } a(i,2)$$

where i lies in [0,3].

Assume that the (M-1)∗(M-2) data block matrix to be parity coded is (for ease of illustration a data block is taken everywhere to be 1 bit in length):

| 1 | 0 | 1 |
|---|---|---|
| 0 | 1 | 1 |
| 1 | 1 | 0 |
| 0 | 1 | 0 |

Using the equations above,

$$S = a(2,0) \text{ XOR } a(1,1) \text{ XOR } a(0,2) = 1 \text{ XOR } 1 \text{ XOR } 1 = 1 \text{ or odd parity.}$$

$$a(0,3) = a(3,0) \text{ XOR } a(2,1) \text{ XOR } a(1,2) \text{ XOR } S = 0 \text{ XOR } 1 \text{ XOR } 1 \text{ XOR } 1 = 1$$

$$a(1,3) = a(3,1) \text{ XOR } a(2,2) \text{ XOR } S = 1 \text{ XOR } 0 \text{ XOR } 1 = 0$$

$$a(2,3) = a(0,0) \text{ XOR } a(3,2) \text{ XOR } S = 1 \text{ XOR } 0 \text{ XOR } 1 = 0$$

$$a(3,3) = a(1,0) \text{ XOR } a(0,1) \text{ XOR } S = 0 \text{ XOR } 0 \text{ XOR } 1 = 1$$

$$a(0,4) = a(0,0) \text{ XOR } a(0,1) \text{ XOR } a(0,2) = 1 \text{ XOR } 0 \text{ XOR } 1 = 0$$

$$a(1,4) = a(1,0) \text{ XOR } a(1,1) \text{ XOR } a(1,2) = 0 \text{ XOR } 1 \text{ XOR } 1 = 0$$

$$a(2,4) = a(2,0) \text{ XOR } a(2,1) \text{ XOR } a(2,2) = 1 \text{ XOR } 1 \text{ XOR } 0 = 0$$

$$a(3,4) = a(3,0) \text{ XOR } a(3,1) \text{ XOR } a(3,2) = 0 \text{ XOR } 1 \text{ XOR } 0 = 1$$

The final encoded version looks as follows:

| DASD0 | DASD1 | DASD2 | DASD3 Diag. P.(odd) | DASD4 Hor. P.(even ) |
|-------|-------|-------|---------------------|----------------------|
| 1 | 0 | 1 | 1 | 0 |
| 0 | 1 | 1 | 0 | 0 |
| 1 | 1 | 0 | 0 | 0 |
| 0 | 1 | 0 | 1 | 1 |

Short Write Operations As Facilitated By the Invention

Assume that M =5 and the following (M-1)*M data block array is stored across the M DASDs.

| DASD0 | DASD1 | DASD2 | DASD3 | DASD4 |
|-------|-------|-------|-------|-------|
| 0 | 0 | 0 | 0 | 0 |
| 1 | 1 | 0 | 1 | 0 |
| 0 | 1 | 1 | 1 | 0 |
| 0 | 1 | 0 | 0 | 1 |

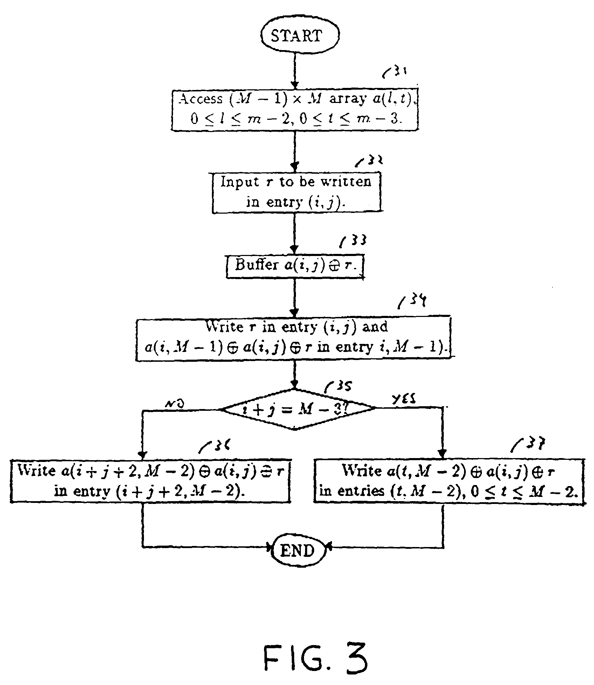

Suppose that we want to replace a(0,1) = 0 by a(0,1)=1. Since entry (0,1) does NOT lie on the reference diagonal defined along (2,0), (1,1), (0,2), then, according to Figure 3, only three reads and three writes are required to effectuate the write update. That is, only the data a(0,1), the diagonal parity a(3,3) and the row parity a(0,4) need to be changed. As is apparent, if we change a(0,1) = 1, then a(3,3)=1 to maintain odd diagonal parity and a(0,4)=1 to keep even row parity. The new array is then

| DASD0 | DASD1 | DASD2 | DASD3 | DASD4 |
|-------|-------|-------|-------|-------|
| 0 | 1 | 0 | 0 | 1 |
| 1 | 1 | 0 | 1 | 0 |

(continued)

| DASD0 | DASD1 | DASD2 | DASD3 | DASD4 |
|---|---|---|---|---|
| 0 | 1 | 1 | 0 | 0 |
| 0 | 1 | 0 | 1 | 1 |

Now, assume that given the array above, it is desired to set a(1,1) = 0. Since it lies on the major diagonal, then all of the diagonal parities must be changed as well as the row parity a(1,4). This gives the new array

| DASD0 | DASD1 | DASD2 | DASD3 | DASD4 |
|---|---|---|---|---|
| 0 | 1 | 0 | 1 | 1 |
| 1 | 0 | 0 | 0 | 1 |
| 0 | 1 | 1 | 0 | 0 |
| 0 | 1 | 0 | 0 | 1 |

Notice that the diagonal parity has switched from odd to even.

Reference should again be made to figure 3 for a flow diagram with a detailed description of short write operations.

Decoding

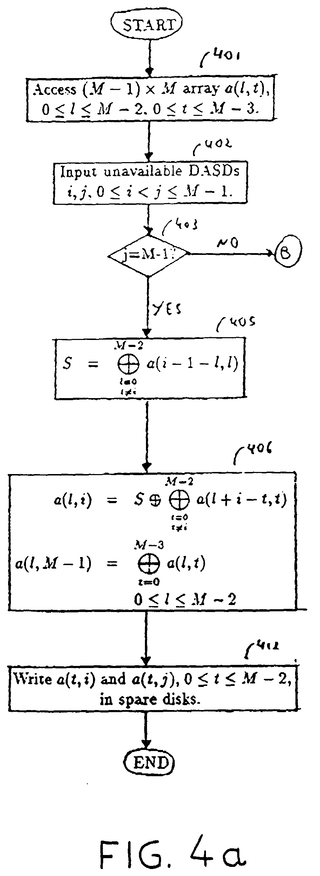

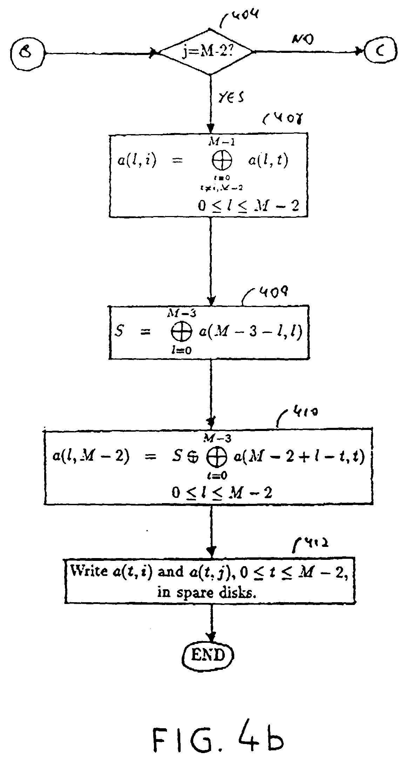

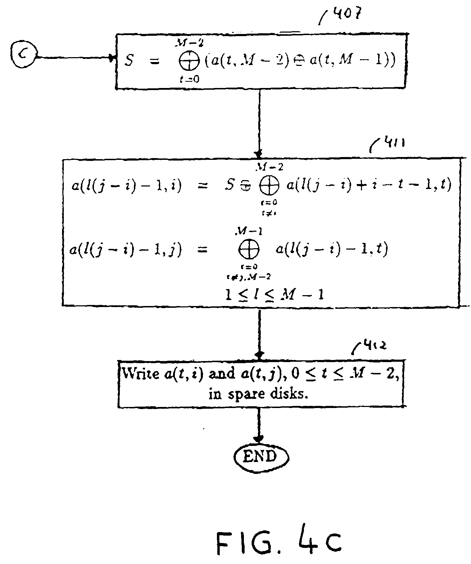

If one of the DASDs fails this is the same as a given column being erased. Thus, if the ith column or DASD were erased, then its contents could be recomputed by an XOR or the remaining columns or DASD in the same manner as the Ouchi patent. However, if two DASDs i and j concurrently fail or the columns are erased, i< j, i and j in the interval [0,M-1], then the problem must be resolved in the way described in Figure 4.

Consider the array below.

| DASD0 | DASD1 | DASD2 | DASD3 | DASD4 |
|---|---|---|---|---|
| 0 | ? | 0 | 1 | ? |
| 1 | ? | 0 | 0 | ? |
| 0 | ? | 1 | 0 | ? |
| 0 | ? | 0 | 0 | ? |

The symbol "?" indicates that the information has been lost in the corresponding entry. In the example, we see that DASDs 1 and 4 are unavailable, i.e., i=1 and j=M-1=4. Now, implementing the decoding according to Figure 4, box 403 sends us to box 405.

There, we estimate

$$S = a(0,0) \text{ XOR } a(3,2) \text{ XOR } a(2,3) = 0 \text{ XOR } 0 \text{ XOR } 0 = 0 \text{ or even parity.}$$

Then, in box 406, we estimate a(t,1) and a(t,4) as follows:

$$a(0,1) = a(1,0) \text{ XOR } a(3,3) \text{ XOR } S = 1 \text{ XOR } 0 \text{ XOR } 0 = 1$$

$$a(1,1) = a(2,0) \text{ XOR } a(0,2) \text{ XOR } S = 0 \text{ XOR } 0 \text{ XOR } 0 = 0$$

$$a(2,1) = a(3,0) \text{ XOR } a(1,2) \text{ XOR } a(0,3) \text{ XOR } S = 0 \text{ XOR } 0 \text{ XOR } 1 \text{ XOR } 0 = 1$$

$$a(3,1) = a(2,2) \text{ XOR } a(1,3) \text{ XOR } S = 1 \text{ XOR } 0 \text{ XOR } 0 = 1$$

$$a(0,4) = a(0,0) \text{ XOR } a(0,1) \text{ XOR } a(0,2) = 0 \text{ XOR } 1 \text{ XOR } 0 = 1$$

$$a(1,4) = a(1,0) \text{ XOR } a(1,1) \text{ XOR } a(1,2) = 1 \text{ XOR } 0 \text{ XOR } 0 = 1$$

$$a(2,4) = a(2,0) \text{ XOR } a(2,1) \text{ XOR } a(2,2) = 0 \text{ XOR } 1 \text{ XOR } 1 = 0$$

$$a(3,4) = a(3,0) \text{ XOR } a(3,1) \text{ XOR } a(3,2) = 0 \text{ XOR } 1 \text{ XOR } 0 = 1$$

Therefore, the reconstructed DASD is

| DASD0 | DASD1 | DASD2 | DASD3 | DASD4 |
|-------|-------|-------|-------|-------|
| 0 | 1 | 0 | 1 | 1 |
| 1 | 0 | 0 | 0 | 1 |
| 0 | 1 | 1 | 0 | 0 |
| 0 | 1 | 0 | 0 | 1 |

Similarly, assume now that the following array is received:

| DASD0 | DASD1 | DASD2 | DASD3 | DASD4 |
|-------|-------|-------|-------|-------|
| ? | 1 | 0 | ? | 1 |
| ? | 0 | 0 | ? | 1 |
| ? | 1 | 1 | ? | 0 |
| ? | 1 | 0 | ? | 1 |

Therefore, DASDs i=0 and j=3 are unavailable. Since j=M-2 , box 404 takes us to box 408, where the a(t,0)'s are estimated as follows:

$$a(0,0) = a(0,1) \text{ XOR } a(0,2) \text{ XOR } a(0,4) = 1 \text{ XOR } 0 \text{ XOR } 1 = 0$$

$$a(1,0) = a(1,1) \text{ XOR } a(1,2) \text{ XOR } a(1,4) = 0 \text{ XOR } 0 \text{ XOR } 1 = 1$$

$$a(2,0) = a(2,1) \text{ XOR } a(2,2) \text{ XOR } a(2,4) = 1 \text{ XOR } 1 \text{ XOR } 0 = 0$$

$$a(3,0) = a(3,1) \text{ XOR } a(3,2) \text{ XOR } a(3,4) = 1 \text{ XOR } 0 \text{ XOR } 1 = 0$$

We next go to box 409, where the diagonal parity is estimated as follows:

$$S = a(2,0) \text{ XOR } a(1,1) \text{ XOR } a(0,2) = 0 \text{ XOR } 0 \text{ XOR } 0 = 0 \text{ or even parity.}$$

Finally, in box 410, the symbols in DASD3 are estimated as follows:

$$a(0,3) = a(3,0) \text{ XOR } a(2,1) \text{ XOR } a(1,2) \text{ XOR } S = 0 \text{ XOR } 1 \text{ XOR } 0 \text{ XOR } 0 = 1$$

$$a(1,3) = a(3,1) \text{ XOR } a(2,2) \text{ XOR } S = 1 \text{ XOR } 1 \text{ XOR } 0 = 0$$

$$a(2,3) = a(0,0) \text{ XOR } a(3,2) \text{ XOR } S = 0 \text{ XOR } 0 \text{ XOR } 0 = 0$$

$$a(3,3) = a(1,0) \text{ XOR } a(0,1) \text{ XOR } S = 1 \text{ XOR } 1 \text{ XOR } 0 = 0$$

The final result of the decoding is then

| DASD0 | DASD1 | DASD2 | DASD3 | DASD4 |
|-------|-------|-------|-------|-------|
| 0 | 1 | 0 | 1 | 1 |
| 1 | 0 | 0 | 0 | 1 |
| 0 | 1 | 1 | 0 | 0 |
| 0 | 1 | 0 | 0 | 1 |

Assume now that the following array is received:

| DASD0 | DASD1 | DASD2 | DASD3 | DASD4 |
|-------|-------|-------|-------|-------|
| ? | 1 | ? | 1 | 1 |
| ? | 0 | ? | 0 | 1 |
| ? | 0 | ? | 1 | 0 |
| ? | 1 | ? | 0 | 1 |

Therefore, DASDs i=0 and j=2 have been erased. Now, since j=2<3=M-2 box 404 takes us to box 407. There, the diagonal parity is estimated as follows:

$$S = a(0,3) \text{ XOR } a(0,4) \text{ XOR } a(1,3) \text{ XOR } a(1,4) \text{ XOR } a(2,3) \text{ XOR } a(2,4)$$

$$\text{XOR } a(3,3) \text{ XOR } a(3,4) = 1 \text{ XOR } 1 \text{ XOR } 0 \text{ XOR } 1 \text{ XOR } 1 \text{ XOR } 0 \text{ XOR } 0 \text{ XOR } 1 = 1.$$

Now the final recursion in box 411 can be determined:

$$a(1,0) = a(0,1) \text{ XOR } a(3,3) \text{ XOR } S = 1 \text{ XOR } 0 \text{ XOR } 1 = 0$$

$$a(1,2) = a(1,0) \text{ XOR } a(1,1) \text{ XOR } a(1,4) = 0 \text{ XOR } 0 \text{ XOR } 1 = 1$$

$$a(3,0) = a(2,1) \text{ XOR } a(1,2) \text{ XOR } a(0,3) \text{ XOR } S = 0 \text{ XOR } 1 \text{ XOR } 1 \text{ XOR } 1 = 1$$

$$a(3,2) = a(3,0) \text{ XOR } a(3,1) \text{ XOR } a(3,4) = 1 \text{ XOR } 1 \text{ XOR } 1 = 1$$

$$a(0,0) = a(3,2) \text{ XOR } a(2,3) \text{ XOR } S = 1 \text{ XOR } 1 \text{ XOR } 1 = 1$$

$$a(0,2) = a(0,0) \text{ XOR } a(0,1) \text{ XOR } a(0,4) = 1 \text{ XOR } 1 \text{ XOR } 1 = 1$$

$$a(2,0) = a(1,1) \text{ XOR } a(0,2) \text{ XOR } S = 0 \text{ XOR } 1 \text{ XOR } 1 = 0$$

$$a(2,2) = a(2,0) \text{ XOR } a(2,1) \text{ XOR } a(2,4) = 0 \text{ XOR } 0 \text{ XOR } 0 = 0$$

The final reconstructed array is:

| DASD0 | DASD1 | DASD2 | DASD3 | DASD4 |
|-------|-------|-------|-------|-------|
| 1 | 1 | 1 | 1 | 1 |
| 0 | 0 | 1 | 0 | 1 |
| 0 | 0 | 0 | 1 | 0 |
| 1 | 1 | 1 | 0 | 1 |

## Claims

1. In a system having a plurality of DASDs, a portion of said plurality of DASDs forming an array of M failure independent DASDs, said subsystem further having means responsive to external commands for accessing subsets of data blocks logically addressed in an (M-1)*(M-2) array of data blocks from said M DASDs, M being a prime number, said data block array having a major or reference diagonal, said data blocks being arranged in said data block array in diagonal and row major order, each diagonal and row order of data blocks having a parity mode, odd or even, one of said plurality of DASDs being designated as spare, a method for encoding and rebuilding of the contents of said array in the event that up to two DASD's from the M DASD array become unavailable, comprising the steps of:

   (a) ascertaining (21) the parity mode of the major diagonal of data blocks in the (M-1)*(M-2) data block array;

   (b) generating (22) an (M-1)*(M) data block array from said (M-1)*(M-2) data array by forming an (M-1)th column by calculating simple parity values from the data blocks in diagonal major order according to the same parity mode, odd or even, of step (a) and by forming an M-th column by calculating for each of the rows simple parity values from the data blocks in row major order according to an even parity mode;

   (c) writing (23) said (M-1)*M data block array onto counterpart locations across the M DASD array or spare equivalent in the event of DASD unavailability; and

   (d) responsive to the unavailability of up to two DASDs, rebuilding the erased or unavailable portion of said data array from no less than (M-2) available DASDs, such that:

      (1) if the up to two failed DASDs consist of the DASDs storing the diagonal parity ((M-1)st DASD) and row parity (Mth DASD) values respectively, then repeating step (b) and writing the reconstituted row and parity values to the spare DASD substitutes for the (M-1)st and Mth DASDs respectively,

      (2) if the up two failed DASDs consist of a DASD (ith DASD) storing data blocks and the DASD (Mth DASD) storing row parity values, then reconstructing the ith DASD by ascertaining (405) the parity mode of the major diagonal, calculating (406) each data block of the ith DASD by XOR'ing only the data blocks lying along the diagonal intersecting the ith DASD according to the ascertained parity mode, and reconstructing the Mth DASD by calculating each row parity value by XOR'ing only the data blocks lying along the row intersecting the Mth DASD, and writing (412) said calculated data blocks and row parity values to the spare DASD substitutes for the ith DASD and Mth DASD respectively,

      (3) if the up to two failed DASDs consist of a DASD (ith DASD) storing data blocks and a DASD ((M-1)st) storing diagonal parity values, then reconstructing the ith DASD by calculating (408) each data block of the ith DASD by XOR'ing each of the remaining data blocks and the row parity value intersecting the ith DASD, and reconstructing the (M-1)st DASD by ascertaining the parity mode of the major diagonal, calculating (410) each diagonal parity value by XOR'ing the data blocks lying along the diagonal intersecting the (M-1)st DASD, together with said parity mode of the major diagonal, and writing (412) said calculated data blocks and diagonal parity values to the spare DASD substitutes for the ith DASD and (M-1)st DASD respectively, and

      (4) if each of the up to two failed DASDs consist of a DASD (ith and jth DASDS) storing data blocks, then ascertaining (407) the parity mode of the major array diagonal as being odd if the XOR of the diagonal parity values is not equal to the XOR of the row parity values and as being even otherwise, ascertaining

EP 0 632 376 B1

(411) each data block value in either the ith or jth DASD as the XOR solution to a single equation with a single unknown formed by either a diagonal of data blocks and diagonal parity value intersecting said each data block being calculated or a row of data blocks and row parity value intersecting said each data block being calculated, and writing (412) said calculated data blocks to the spare DASD substitutes for the ith and jth DASDs.

2. The method according to claim 1, wherein said accessing means includes means for assigning spare capacity assigned among the M DASDs in a predetermined manner, means for substituting spare DASDs for the failed ones, and further wherein step (d) includes writing said rebuilt portion either to counterpart ones of said plurality of DASDs operatively designated as spares or to spare space available on no less than M-2 remaining DASDs.

3. The method according to claim 1, wherein if M is not a prime number then causing steps (b), (c), and (d) to emulate a data block array expanded to include additional columns of uniform binary value to yield an effective array (M'-1)*M' where M' constitutes a prime number larger than M.

4. The method according to claim 1, wherein said method executes at least one small write access through said access means to the (M-1)*M data array stored on array of M DASDs, a first and a second DASD storing simple parity values while M-2 other DASDs storing data blocks, and wherein said method further comprises the steps of:

   (a) ascertaining (35) whether the data block to be modified lies on the main or reference diagonal of the data block array;

   (b) in the event (36) that the block to be modified is not located on the main diagonal, then

      (1) reading the old data block from the DASD storing said block and reading the old diagonal and old row parity values from the first and second redundant DASDs respectively;

      (2) determining a new diagonal parity value by XOR'ing the old data block, new data block, and old diagonal parity value, and determining a new row parity value by XOR'ing old data block, new data block, and old row parity value;
      and

      (3) writing said new data block, and new diagonal and row parity values in place in the data block storing DASD and the first and second redundant DASDs, respectively;

   (c) in the event (37) that the block to be modified is located on the main diagonal, then

      (1) reading the old data block from the DASD storing said block, the old row parity value from the second redundant DASD, and M diagonal parity values from the first redundant DASD;

      (2) determining each of M-1 new diagonal parity values by XOR'ing each old counterpart diagonal parity value, the old data block and the new data block, and determining a new row parity value by XOR'ing the old data block, the new data block, and the old row parity value; and

      (3) writing said new data block, new row parity value, and M new diagonal parity values to ccunterpart ones of the M DASDs.

5. The method according to claim 4, wherein step (c) (3) further includes the step of writing said data blocks and parity values in place in said counterpart DASDs.

6. The method of claim 4, wherein the calculation of the (M-1) new parity values responsive to the write update command to modify a data block located on the major diagonal includes logically complementing the counterpart old diagonal parity values.

**Patentansprüche**

1. In einem System mit einer Vielzahl DASDs, (Direct Access Storage Device = Direktzugriffsspeicher) bei dem ein Teil der Vielzahl DASDs ein Array aus M ausfallunabhängigen DASDs bildet, wobei das Subsystem weiterhin Mittel besitzt, die auf externe Befehle zum Zugriff auf Teilmengen von Datenblöcken reagieren, die logisch in einem (M - 1) * (M - 2) - Array aus Datenblöcken von den M DASDs adressiert werden, wobei M eine Primzahl darstellt und das Datenblockarray eine Haupt- oder Bezugsdiagonale besitzt, wobei die Datenblöcke in dem Datenblockarray in Diagonal- und Zeilenhauptpositionen angeordnet sind und jede Diagonal- und Zeilenposition von Datenblöcken einen Paritätsmodus, ungerade oder gerade, besitzt und wobei eines der Vielzahl von DASDs als Ersatz festgelegt wurde, umfaßt ein Verfahren zur Codierung und Wiederherstellung der Bestandteile des Arrays für den Fall, daß bis zu zwei DASDs von dem M DASD-Array nicht verfügbar sind, die folgenden Schritte:

(a) Feststellen (21) des Paritätsmodus der Hauptdiagonale von Datenblöcken in dem (M - 1) * (M - 2) Datenblockarray;

(b) Erstellen (22) eines (M - 1) * (M) Datenblockarrays aus dem (M - 1) * (M - 2) Datenarray durch Bildung einer (M - 1)-ten Spalte durch Berechnung der einfachen Paritätswerte aus den Datenblöcken in der Diagonalhauptposition gemäß dem gleichen Paritätsmodus, ungerade oder gerade, von Schritt (a) durch Bildung der M-ten Spalte durch Berechnung der einfachen Paritätswerte für jede der Zeilen aus den Datenblöcken in Zeilenhauptposition entsprechend einem geraden Paritätsmodus;

(c) Schreiben (23) des (M - 1) * M Datenblockarrays auf die entgegengesetzten Positionen über das M DASD-Array oder das Ersatzäquivalent im Falle der Nichtverfügbarkeit des DASD; und

(d) Reagieren auf die Nichtverfügbarkeit von bis zu zwei DASDs, Wiederherstellen des gelöschten oder nichtverfügbaren Bereiches des Datenarrays aus nicht weniger als (M - 2) verfügbaren DASDs, so daß:

(1) wenn die bis zu zwei ausgefallenen DASDs aus den DASDs bestehen, die die Diagonalparitätswerte ((M - 1)-ter DASD) beziehungsweise Zeilenparitätswerte (M-ter DASD) speichern, der Schritt (b) wiederholt wird und die wiederhergestellten Zeilen- und Paritätswerte zu den Ersatz-DASD-Substituten für die (M - 1)-ten beziehungsweise M-te DASDs geschrieben werden,

(2) wenn die bis zu zwei ausgefallenen DASDs aus einem DASD (i-ter DASD), der Datenblöcke speichert, und dem DASD (M-ter DASD) besteht, der Zeilenparitätswerte speichert, der i-te DASD rekonstruiert wird, indem der Paritätsmodus der Hauptdiagonale festgestellt wird (405), jeder Datenblock des i-ten DASD durch XODER-Verknüpfung von nur den Datenblöcken berechnet wird (406), die entlang der Diagonale schneidet, die den i-ten DASD gemäß dem festgestellten Paritätsmodus liegen, und der M-te DASD durch Berechnung von jedem Zeilenparitätswert rekonstruiert wird, indem nur die Datenblöcke XODER-verknüpft werden, die entlang der Zeilen liegen, die den M-ten DASD schneidet, und die berechneten Datenblock- und Zeilenparitätswerte in die Ersatz-DASD-Substituten für der den i-ten beziehungsweise M-ten DASD geschrieben werden,

(3) wenn die bis zu zwei ausgefallenen DASDs aus einem DASD (i-ter DASD), der Datenblöcke speichert, und einem DASD ((M - 1)-ter), der Diagonalparitätswerte speichert, bestehen, der i-te DASD durch Berechnung (408) von jedem Datenblock des i-ten DASD durch XODER-Verknüpfung von jedem der verbleibenden Datenblöcke und dem Zeilenparitätswert, der den i-ten DASD schneidet, rekonstruiert wird und der (M - 1)-te DASD durch Feststellen des Paritätsmodus der Hauptdiagonale rekonstruiert wird, jeder Diagonalparitätswert durch XODER-Verknüpfung der Datenblöcke, die entlang der Diagonalen liegen, die den (M - 1)-ten DASD schneidet, gemeinsam mit dem Paritätsmodus der Hauptdiagonalen, berechnet wird (410), und Schreiben (412) der berechneten Datenblöcke und Diagonalparitätswerte zu dem Ersatz-DASD-Substituten für den i-ten DASD beziehungsweise den (M - 1)-ten DASD, und

(4) wenn jeder der bis zu zwei ausgefallenen DASDs aus einem DASD (i-te und j-te DASDs) besteht, der Datenblöcke speichert, der (407) Paritätsmodus der Hauptmatrixdiagonalen als ungerade erkannt wird, wenn die XODER-Verknüpfung der Diagonalparitätswerte nicht gleich der XODER-Verknüpfung der Zeilenparitätswerte ist und dieser sonst als gerade erkannt wird, wenn festgestellt wird (411), daß jeder Datenblockwert in entweder dem i-ten oder j-ten DASD als die Lösung der XODER-Verknüpfung als eine einzelne Gleichung mit einer einzigen Unbekannten, die von entweder einer Diagonalen an Datenblöcken und einem Diagonalparitätswert gebildet wird, der jeden der Datenblöcke schneidet, die berechnet werden, oder die von einer Zeile an Datenblöcken und einem Zeilenparitätswert gebildet wird, der jeden berechneten Datenblock schneidet und die berechneten Datenblöcke in die Ersatz-DASD-Substituten für die i-ten und j-ten DASDs als Ersatz schreibt (412).

2. Verfahren gemäß Anspruch 1, wobei das Mittel für den Zugriff Mittel für das Zuweisen von Ersatzkapazität, die unter den M DASDs in einer vorher festgelegten Weise zugewiesen wurden, sowie Mittel zur Substituierung von Ersatz-DASDs für die ausgefallenen umfaßt, und wobei weiterhin Schritt (d) das Schreiben des wiederhergestellten Bereiches entweder zu den Gegenstücken der Vielzahl DASDs, die operativ als Ersatz festgelegt wurden, oder auf einen Ersatzplatz, der auf nicht weniger als M - 2 verbleibenden DASDs verfügbar ist, umfaßt.

3. Verfahren gemäß Anspruch 1, wobei, wenn M keine Primzahl ist, bewirkt wird, daß die Schritte (b), (c) und (d) ein Datenblockarray emulieren, das erweitert wurde, um zusätzliche Spalten von einheitlichem Binärwert zu umfassen, um ein effektives Array (M' -1) * M' hervorzubringen, wobei M' eine Primzahl größer als M darstellt.

4. Verfahren gemäß Anspruch 1, wobei das Verfahren wenigstens einen kleinen Schreibzugriff über das Zugriffsmittel auf das (M - 1) * M Datenarray, das in dem Array aus M DASDs gespeichert ist, ausführt, wobei ein erster und ein zweiter DASD einfache Paritätswerte speichert, während M - 2 andere DASDs Datenblöcke speichern, und wobei das Verfahren weiterhin die folgenden Schritte umfaßt:

(a) Feststellen (35), ob der zu modifizierende Datenblock entweder auf der Hauptdiagonalen oder der Referenzdiagonalen des Datenblockarrays liegt;

(b) im Falle (36), daß sich der zu modifizierende Datenblock nicht auf der Hauptdiagonalen befindet,

(1) Lesen des alten Datenblockes aus dem DASD, der den Block speichert, und Lesen der alten Diagonal- und alten Zeilenparitätswerte aus den ersten beziehungsweise zweiten DASDs;

(2) Bestimmen eines neuen Diagonalparitätswertes durch XODER-Verknüpfung des alten Datenblockes, neuen Datenblockes und alten Diagonalparitätswertes und Bestimmen eines neuen Zeilenparitätswertes durch XODER-Verknüpfung des alten Datenblockes, neuen Datenblockes und alten Zeilenparitätswertes; und

(3) Schreiben des neuen Datenblockes und neuen Diagonal- und Zeilenparitätswertes an die Stelle in den datenblockspeichernden DASD und den ersten beziehungsweise zweiten redundanten DASDs;

(c) im Falle (37), daß der zu modifizierende Block sich auf der Hauptdiagonale befindet,

(1) Lesen des alten Datenblockes aus dem DASD, der den Block speichert, des alten Paritätswertes von dem zweiten redundanten DASD und M Diagonalparitätswerte von dem ersten redundanten DASD;

(2) Bestimmen jedes der M - 1 neuen Diagonalparitätswerte durch XODER-Verknüpfung jedes alten Gegenstückes zum Diagonalparitätswert, des alten Datenblockes und des neuen Datenblockes und Bestimmen eines neuen Zeilenparitätswertes durch XODER-Verknüpfung des alten Datenblockes, des neuen Datenblockes und des alten Zeilenparitätswertes; und

(3) Schreiben des neuen Datenblockes, neuen Zeilenparitätswertes und M neuer Diagonalparitätswerte zu den Gegenstücken der M DASDs.

5. Verfahren nach Anspruch 4, wobei Schritt (c) (3) weiterhin den Schritt des Schreibens der Datenblöcke und Paritätswerte an die Stelle der Gegenstücke zu den DASDs enthält.

6. Verfahren nach Anspruch 4, wobei die Berechnung der (M - 1) neuen Paritätswerte, die auf den Schreibaktualisierungsbefehl zur Veränderung eines Datenblockes auf der Hauptdiagonalen reagieren, die logische Vervollständigung des zugehörigen alten Diagonalparitätswertes enthält.

## Revendications

1. Dans un système ayant une pluralité de DASD (Direct Access Storage Devices, c'est -à-dire dispositifs de mémoire à accès direct) une partie de ladite pluralité de DASD formant un réseau de M DASD indépendants en cas de défaillance, ledit sous-système comprenant en outre un moyen qui, en réponse à des commandes externes, permet d'accéder à des sous-ensembles de blocs de données à adressage logique dans un réseau de (M-1)*(M-2) blocs de données à partir des dits M DASD, M étant un nombre premier, ledit réseau de blocs de données ayant une grande diagonale ou de référence, les dits blocs de données étant arrangés dans ledit réseau de blocs de données en ordre principal de diagonale et de rang, chaque ordre de diagonale et de rang de blocs de données ayant un mode de parité, pair ou impair, l'un des dits DASD de ladite pluralité de DASD étant désigné comme dispositif de réserve, une méthode de codage et de reconstruction du contenu du dit réseau dans le cas où jusqu'à deux DASD au plus, du réseau de M DASD se trouveraient non-disponibles, comprenant les phases suivantes:

(a) vérifier (21) le mode de parité de la grande diagonale des blocs de données dans le réseau de (M-1)*(M-2) blocs de données;

(b) créer (22) un réseau de (M-1)*(M) blocs de données à partir du dit réseau de (M-1)*(M-2) de données en formant une (M-1)$^{ème}$ colonne en calculant les valeurs de parités simples des blocs de données en ordre principal de diagonale d'après le même mode de parité, pair ou impair, que dans la phase (a), et en formant une M$^{ème}$ colonne en calculant pour chacun des rangs les valeurs de parité simples à partir des blocs de données disposés en ordre principal de rang d'après un mode de parité paire;

(c) écrire (23) ledit réseau de (M-1)*(M) blocs de données sur des emplacements équivalents dans le réseau des M DASD ou dans le dispositif de réserve, dans l'éventualité d'une indisponibilité de DASD; et

(d) dans le cas où jusqu'à deux DASD au plus se trouveraient non-disponibles, reconstruire la partie effacée ou non-disponible du dit réseau de données à partir d'au moins (M-2) DASD disponibles, de la manière suivante:

(1) si les, au plus, deux DASD défectueux sont les DASD qui ont enregistré respectivement les valeurs de parité de diagonale ((M-1)$^{ème}$ DASD) et de parité de rang (M$^{ème}$ DASD), répéter alors la phase (b) et écrire les valeurs de parité de diagonale et de rang reconstituées dans les emplacements de réserve des DASD pour les (M-1)$^{ème}$ et M$^{ème}$ DASD, respectivement,

(2) si les deux, au plus, DASD défectueux sont un DASD (i$^{ème}$ DASD) qui enregistre des blocs de données et le DASD (M$^{ème}$ DASD) qui enregistre les valeurs de parité de rang, reconstruire alors le i$^{ème}$ DASD en vérifiant (405) le mode de parité de la diagonale principale, calculant (406) chaque bloc de données du i$^{ème}$ DASD en effectuant le produit OU-exclusif des seuls blocs de données disposés le long de la diagonale rencontrant le i$^{ème}$ DASD suivant le mode de parité vérifié, et reconstruire le M$^{ème}$ DASD en calculant chaque valeur de parité de rang en faisant le produit OU-exclusif des seuls blocs de données du rang rencontrant le M$^{ème}$ DASD, et écrire (412), dans les dispositifs de remplacements des DASD pour, respectivement, le i$^{ème}$ DASD et le M$^{ème}$ DASD, les dits blocs de données et valeurs de parité de rang qui ont été calculés,

(3) si les deux, au plus, DASD défectueux sont un DASD (i$^{ème}$ DASD) qui enregistre des blocs de données et un DASD ((M-1)$^{ème}$ DASD) qui enregistre les valeurs de parité de diagonale, reconstruire alors le i$^{ème}$ DASD en calculant (408) chaque bloc de données du i$^{ème}$ DASD en effectuant le produit OU- exclusif de chacun des blocs de données restants et de la valeur de parité de rang rencontrant le i$^{ème}$ DASD, et reconstruire le (M-1)$^{ème}$ DASD en vérifiant le mode de parité de la grande diagonale, calculant (410) chaque valeur de parité de diagonale en faisant le produit OU- exclusif des blocs de données disposés sur la diagonale rencontrant le M(-1)$^{ème}$ DASD avec ledit mode de parité de la diagonale principale, et écrire (412), dans les dispositifs de remplacements des DASD, les dits blocs de données et valeurs de parité de diagonale qui ont été calculés, pour le i$^{ème}$ DASD et le (M-1)$^{ème}$ DASD respectivement, et

(4) si chacun des jusqu'à deux DASD, au plus, est un DASD qui enregistre des blocs de données (i$^{ème}$ et j$^{ème}$ DASD), vérifier alors que (407) le mode de parité de la grande diagonale du réseau est bien impair si le produit OU-exclusif des valeurs de parité de diagonale n'est pas égal au produit OU- exclusif des valeurs de parité de rang et pair le cas contraire, vérifier (411) que la valeur de chaque bloc de données dans l'un ou l'autre du i$^{ème}$ ou du j$^{ème}$ DASD est la solution OU- exclusive d'une unique équation à une seule inconnue formée soit par une diagonale de blocs de données et une valeur de parité de diagonale rencontrant ledit bloc de données qui est calculé ou par un rang de blocs de données et la valeur de parité de rang coupant ledit bloc de données calculé, et écrire (412) les dits blocs de données calculés dans les dispositifs de remplacement de DASD utilisés comme réserve, pour le $i^{ème}$ et pour le $j^{ème}$ DASD.

2. Méthode selon la revendication 1, où ledit moyen d'accès comprend un moyen pour assigner de façon prédéterminée la capacité de réserve assignée parmi les M DASD, un moyen pour substituer des DASD de réserve aux DASD défectueux, et où en outre, la phase (d) comprend l'écriture de ladite partie reconstruite soit dans des dispositifs équivalents de ladite pluralité de DASD dont la fonction désignée est une fonction de réserve, soit dans un espace de réserve disponible sur pas moins de (M-2) des DASD restants.

3. Méthode selon la revendication 1, où si M n'est pas un nombre premier, alors les phases (b), (c) et (d) émulent un réseau de blocs de données étendu pour inclure des colonnes supplémentaires de valeur binaire uniforme pour produire un réseau réel (M'-1)*M', où M' est un nombre premier supérieur à M.

4. Méthode selon la revendication 1, où ladite méthode exécute au moins un court accès en vue d'une écriture, par le biais du dit moyen d'accès au dit réseau de données (M-1)*M enregistré sur le réseau des M DASD, un premier et un deuxième DASD enregistrant des valeurs de parité simples alors que (M-2) autres DASD enregistrent des blocs de données, et où ladite méthode comprend en outre les phases suivantes:

(a) vérifier (35) si le bloc de données qui doit être modifié se trouve sur la grande diagonale ou diagonale de référence du réseau de blocs de données;

(b) dans le cas (36) où le bloc à modifier n'est pas situé sur la diagonale principale, alors

(1) lire l'ancien bloc de données dans le DASD qui contient ledit bloc et lire les anciennes valeurs de parité de diagonale et de rang dans les premier et deuxième DASD redondants, respectivement;

(2) déterminer une nouvelle valeur de parité de diagonale en effectuant le produit OU- exclusif de l'ancien bloc de données, du nouveau bloc de données, et de la valeur de parité de diagonale ancienne, et déterminer une nouvelle valeur de parité de rang en effectuant le produit OU- exclusif de l'ancien bloc de données, du nouveau bloc de données et de la valeur de parité de rang ancienne; et

(3) écrire ledit nouveau bloc de données, et les nouvelles valeurs de parité de diagonale et de rang à leur place dans le DASD d'enregistrement des blocs de données et dans les premier et deuxième DASD redondants, respectivement;

(c) dans le cas (37) où le bloc de données à modifier est situé sur la diagonale principale, alors

(1) lire l'ancien bloc de données dans le DASD qui a ledit bloc en mémoire, l'ancienne valeur de parité de rang dans le deuxième DASD redondant, et M valeurs de parité de diagonale dans le premier DASD redondant;

(2) déterminer chacune des M-1 nouvelles valeurs de parité de diagonale en effectuant le produit OU-exclusif de chaque ancienne valeur de parité de diagonale équivalente, l'ancien bloc de données et le nouveau bloc de données, et déterminer une valeur de parité de la nouvelle diagonale en effectuant le produit OU- exclusif de l'ancien bloc de données, du nouveau bloc de données, et de la valeur de parité de l'ancien rang; et

(3) écrire ledit nouveau bloc de données, la nouvelle valeur de parité de rang, et les M nouvelles valeurs de parité de diagonale dans des dispositifs équivalents aux M DASD.

5. Méthode selon la revendication 4, où la phase (c) (3) comprend en outre une phase d'écriture des dits blocs de données et valeurs de parité en place, dans les dits DASD équivalents.

6. Méthode selon la revendication 4, où le calcul des (M-1) valeurs de parité nouvelles en réponse à la commande de mise à jour d'écriture pour modifier un bloc de données situé sur la grande diagonale comprend de compléter logiquement les anciennes valeurs de parité de diagonale équivalentes.

ELEMENTS OF A DASD ARRAY

FIG. 1

START

$20

Access $(M-1) \times (M-2)$ data array $a(l,t)$,
$0 \le l \le M-2$, $0 \le t \le M-3$.

$21$

$$S = \bigoplus_{l=0}^{M-3} a(M-3-l, l)$$

$22$

$$a(l, M-2) = S \oplus \bigoplus_{t=0}^{M-3} a(M-2+l-t, t)$$

$$a(l, M-1) = \bigoplus_{t=0}^{M-3} a(l,t)$$

$$0 \le l \le M-2$$

$23$

Write $a(l, M-2)$ and $a(l, M-1)$,
$0 \le l \le M-2$, in disks
M-2 and M-1 respectively.

END

# FIG. 2

START

/31

Access $(M-1) \times M$ array $a(l,t)$,
$0 \leq l \leq m-2, 0 \leq t \leq m-3$.

/32

Input $r$ to be written
in entry $(i,j)$.

/33

Buffer $a(i,j) \oplus r$.

/34

Write $r$ in entry $(i,j)$ and
$a(i, M-1) \oplus a(i,j) \oplus r$ in entry $i, M-1$).

/35

$i+j = M-3$?

NO

YES

/36

Write $a(i+j+2, M-2) \oplus a(i,j) \oplus r$
in entry $(i+j+2, M-2)$.

/37

Write $a(t, M-2) \oplus a(i,j) \oplus r$
in entries $(t, M-2), 0 \leq t \leq M-2$.

END

FIG. 3

START

401

Access $(M-1) \times M$ array $a(l,t)$,
$0 \le l \le M-2$, $0 \le t \le M-3$.

402

Input unavailable DASDs
$i, j, 0 \le i < j \le M-1$.

403

$j=M-1?$ — NO → B

YES

405

$$S = \bigoplus_{\substack{l=0 \\ l \neq i}}^{M-2} a(i-1-l, l)$$

406

$$a(l,i) = S \oplus \bigoplus_{\substack{t=0 \\ t \neq i}}^{M-2} a(l+i-t, t)$$

$$a(l, M-1) = \bigoplus_{t=0}^{M-3} a(l, t)$$

$$0 \le l \le M-2$$

412

Write $a(t,i)$ and $a(t,j)$, $0 \le t \le M-2$,
in spare disks.

END

FIG. 4a

FIG. 4b

$$/407$$

$$S = \bigoplus_{t=0}^{M-2} (a(t, M-2) \oplus a(t, M-1))$$

$$/411$$

$$a(l(j-i)-1, i) = S \oplus \bigoplus_{\substack{t=0 \\ t \neq i}}^{M-2} a(l(j-i)+i-t-1, t)$$

$$a(l(j-i)-1, j) = \bigoplus_{\substack{t=0 \\ t \neq j, M-2}}^{M-1} a(l(j-i)-1, t)$$

$$1 \le l \le M - 1$$

$$/412$$

Write $a(t, i)$ and $a(t, j)$, $0 \le t \le M - 2$, in spare disks.

END

## FIG. 4c